# EUROPEAN PATENT APPLICATION

(11) **EP 1 435 668 A1**
(43) Date of publication of application: **07.07.2004**
(21) Application number: 02779890.9
(22) Date of filing: 20.09.2002
(51) Int. Cl.: H01L 39/20, C01G 1/00, C01G 3/00, C30B 29/22, H01B 12/06, H01B 13/00, H01F 6/06

(54) **PERMANENT CURRENT SWITCH MATERIAL AND PRODUCTION METHOD THEREFOR**

(30) Priority: 21.09.2001 JP 2001288994
(71) Applicant: INTERNATIONAL SUPERCONDUCTIVITY TECHNOLOGY CENTER, Tokyo 105-0004 (JP)
(72) Inventor: IZUMI, Teruo, c/o Superconductivity Research Lab., 1-10-13, Shinonome, Koto-ku, Tokyo 135-0 (JP); YAO, Xin, c/o Superconductivity Research Lab., 1-10-13, Shinonome, Koto-ku, Tokyo 135-0 (JP); KAI, Masahiko, c/o Superconductivity Research Lab., 1-10-13, Shinonome, Koto-ku, Tokyo 135-0 (JP); NOMURA, Katsumi, c/o Superconduct. Research Lab., 1-10-13, Shinonome, Koto-ku, Toky0 135-0 (JP); SHIOHARA, Yuh, c/o Superconductivity Research Lab., -10-13, Shinonome, Koto-ku, Tokyo 135-0 (JP)
(74) Representative: Vetter, Hans, Dipl.-Phys.Dr.
(86) International application number: PCT/JP2002/009741
(87) International publication number: WO 2003/028120

(57) **Abstract**

A persistent current switch which operates at operating temperature higher than that of a metallic superconducting wire, and which is smaller, lighter and higher in electric resistance in a normal conducting state than a superconducting Ag sheathed wire. An LPE film formed in a meandering shape or a spiral shape for an elongated conducting route can fulfill the above requirements. The shape can be controlled by LPE growth from a pre-processed seed film or by processing after growth.

## Description

### TECHNICAL FIELD

This invention relates to a material for a persistent current switch applicable to superconducting technology applied apparatus which make use of a persistent current mode, and to a production method therefor.

### BACKGROUND ART

Superconducting electromagnetic propulsion ships, superconducting magnetically levitated vehicles, and superconducting magnetic energy storage systems are some examples of superconducting technology applied apparatus which adopt a persistent current mode.

The above apparatus (systems) generally use metallic superconductors such as NbTi, Nb₃Sn, etc. as superconducting wire materials.

A persistent current switch which accompanies the above apparatus (systems) also uses metallic superconductors such as NbTi, Nb₃Sn, etc. as conducting materials.

Metallic superconductors such as NbTi, Nb₃Sn, etc. must be cooled down to or under the superconducting critical temperature (of 4.2K as a general rule) in liquid helium or a cryocooler.

Research and development on implementation of oxide superconductors, as superconducting wire materials of superconducting technique applied apparatus which take advantage of persistent current, have been continued, instead of use of the conventional metallic superconductors.

Several merits that can be obtained by utilization of oxide superconducting wire materials are mainly come from the fact that oxide superconducting wire materials allow increase in operating temperature. (reduction in cooling costs, downsizing and lightening of cooling apparatus, stabilized superconduction due to rise in specific heat, etc.)

There are hardly any persistent current switches which take advantage of oxide superconducting wire materials.

If a persistent current switch is produced using a metallic superconducting wire material, additional cooling is required for the persistent current switch. Therefore, there is a possibility that the merits of adopting the oxide superconducting wire material in an apparatus body may be set off.

Assuming that a persistent current switch is produced using an Ag sheathed wire material which typifies a Bi oxide superconducting wire material, large increase in volume and weight of the persistent current switch cannot be avoided. This is because, since Ag as a sheath material has low electric resistivity, very long conductor length is required in order to obtain electric resistance necessary for a persistent current switch in a normal conducting state.

Large increase in volume and weight of the switch leads to increase in heat capacity. Accordingly, a trouble (problem) occurs that time and energy required for temperature lifting and lowering may increase. (deterioration in switching speeds and increase in cooling costs)

Assuming that an RE123 oxide superconducting bulk material is used as a persistent current switch, it is extremely difficult, from the points of view of production process and mechanical strength, to realize a wire material which is small in cross section or long in length. That is, even if a bulk material has high superconducting electric resistivity, electric resistance of the bulk material becomes small in a normal conducting state, because of its largeness in cross section and shortness in length. Accordingly, it is difficult to fulfill required specifications.

One object of the present invention which was made to solve the above problem is to provide a persistent current switch which operates at operating temperature higher than that of a metallic superconducting wire, and which is smaller, lighter and higher in electric resistance in a normal conducting state than an oxide superconducting Ag sheathed wire material.

### DISCLOSURE OF THE INVENTION

The present invention, which was made to attain the above object, provides a persistent current switch which is small but long in conducting path length, by forming a conductor portion of the persistent current switch into a meandering or spiral shape, thus achieving high electric resistance in a normal conducting state.

It is desirable that the conductor portion uses an LPE-grown crystal film which has a high critical current density property and which is easy to increase and control film thickness.

One example of crystal materials which are appropriate to be grown by LPE is an RE 123 superconductor. Here, RE represents Y and rare-earth elements. RE may be interpreted as either one of the elements or a combination of such elements. Other superconducting materials can be also used instead of the RE123 superconductor.

In order to form the conductor portion into a meandering or spiral shape, there are two methods of controlling shapes. One is to pre-process a seed crystal film and the other is to process the film after LPE growth. Either shape control method can be used to obtain a desired shape. The shape processing may be performed either physically or chemically.

Superconducting critical temperature (Tc) of the RE123 superconductor can be controlled by adding an element such as Zn, Mg, etc. or a combination of such elements. Tc control permits appropriate setting of a temperature difference between when the persistent current switch is on (superconducting current conduction) and when the persistent current switch is off (normal conducting state). This means that, with the features of a persistent current switch being small and light in the present invention, high switch responsiveness can be achieved.

Also, by using an Nd123 or Sm123 superconductor as the RE123 superconductor and controlling a composition ratio of RE and Ba, the superconducting critical temperature (Tc) can be adjusted so that 30K□...Tc□...96K. Accordingly, the same effects as above can be expected.

### BRIEF DESCRIPTION OF THE DRAWINGS

Fig. 1 is an explanatory view of a meandering-shaped seed film;

Fig. 2 is a conceptual diagram of LPE film forming; and

Fig. 3 is an explanatory view of an LPE-grown film which succeeds a meandering shape of the seed film.

### BEST MODE FOR CARRYING OUT THE INVENTION

Preferred embodiments of the present invention will now be described with reference to the accompanying drawings. The embodiments of the present invention should not be limited to embodiments below, and other variations might be possible without departing from the technical scope of the invention.

### [First Example]

A Y123 poly crystalline seed film, having thickness of approximately 0.1ìm, was grown onto an MgO (100) single crystalline substrate of 20×20×0.5mm³ by vapor deposition (pulsed laser deposition).

It was confirmed by an x-ray diffraction apparatus that c-axis of the seed film crystal (Y123) is oriented perpendicular to the substrate surface.

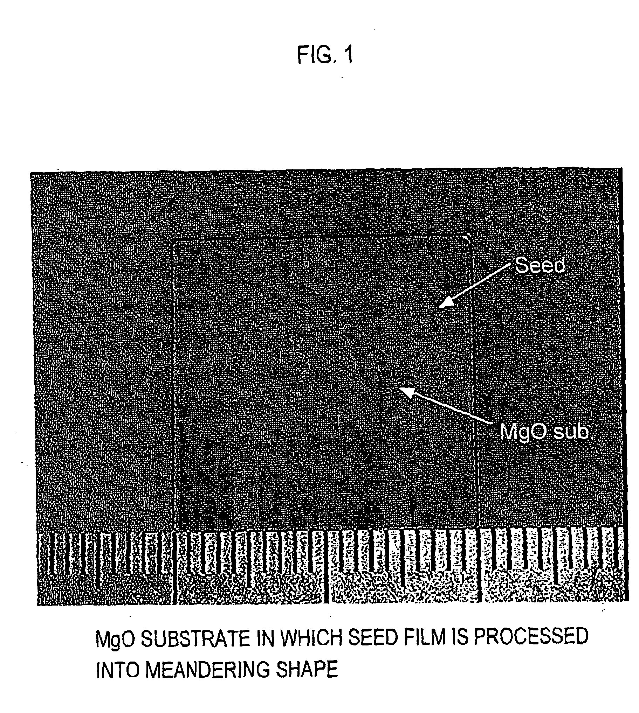

In order to form the seed film into a meandering shape of 3mm width and 2mm pitch, a mask was applied to the seed film using a polyimide film, and chemical etching was performed with a dilute nitric acid solution (of approximately 0.01N). The film was then washed with ethanol and the mask was removed. As a result, the seed film having a meandering shape as shown in Fig. 1 was obtained.

The following steps were performed for LPE growth. A Y₂O₃ crucible, having internal diameter of 50mm and height of 50mm, was filled with Y₂BaCuO₅ powder (of approximately 15g), as a solute supply source, and 3BaO-7CuO powder (of approximately 240g), as a solvent. Heated to about 1,000°C, the crucible was sufficiently kept at the temperature until the 3BaO-7CuO powder completely melts.

Thereafter, surface temperature of the liquid was lowered to about 984°C and bottom temperature of the liquid was lowered to about 988°C so that a vertical temperature gradient is formed. The liquid surface was adjusted to be supersaturated for growth of Y123 phase.

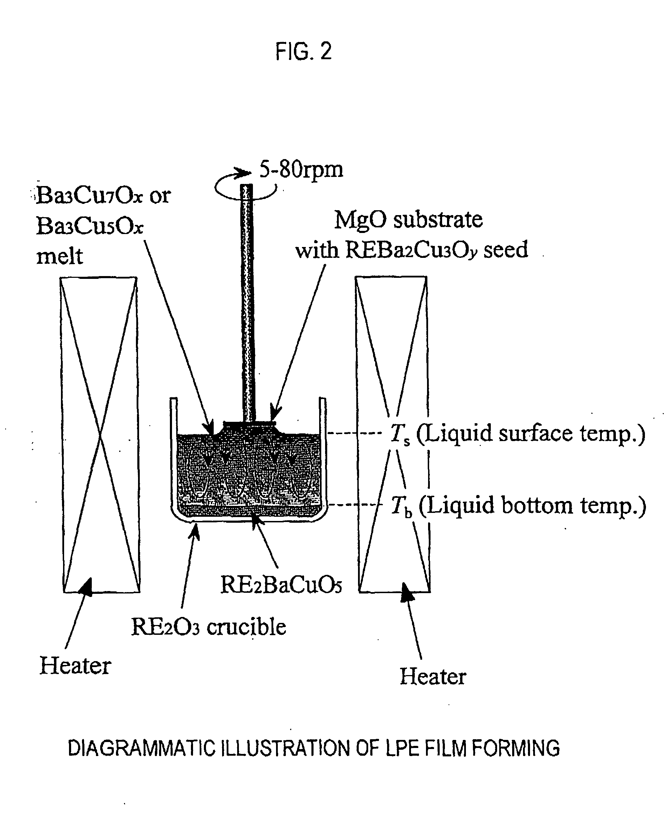

To form an LPE film, the substrate surface was fixed perpendicular to a pulling rod. The seed film was placed onto the supersaturated liquid surface. Then, with rotation of 20 rpm for 20 minutes, the seed film was grown by LPE. Fig. 2 shows a conceptual diagram of LPE film forming.

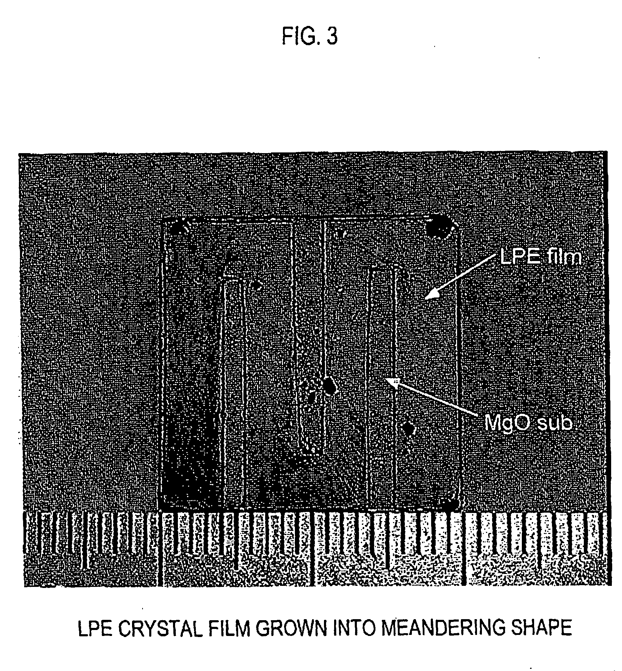

It was confirmed that the LPE-grown film obtained is Y123 crystal having thickness of about 20ìm, and the meandering shape of the seed film is maintained along the surface to an accuracy of several tens of im. The external view of the film is shown in Fig. 3.

Subsequently, the LPE-grown film was heat-treated at 500°C for 200h in a pure oxygen gas-stream and the Y123 crystal was turned to superconducting phase.

The LPE-grown film was tested for conduction by the DC four-probe resistive method without any external magnetic fields being applied. The result showed that superconducting critical temperature of the film is about 90K.

Additionally, the film was tested for conduction in liquid nitrogen (at about 77K) by the DC four-probe resistive method without any external magnetic fields being applied. It was found that critical current of the film is about 300A. These results confirmed that the LPE-grown film obtained is an excellent superconductor.

Subsequently, electric resistance in a normal conducting state at about 100K was evaluated. It was found that resistance of the film is about 4Ù. As a result, it was confirmed that the LPE film of the present invention has high electric resistivity in a normal conducting state.

### [Second Example]

A Y123 poly crystalline seed film, having thickness of approximately 0.1ìm, was grown onto an MgO (100) single crystalline substrate of 20×20×0.5mm³ by vapor deposition (thermal reactive co-evaporation).

It was confirmed by an x-ray diffraction apparatus that c-axis of the seed film crystal (Y123) is oriented perpendicular to the substrate surface.

In order to form the seed film into a meandering shape of 3mm width and 2mm pitch, physical etching was performed only to a seed crystal film portion using a laser processing apparatus. As a result, the seed film having a meandering shape was obtained.

The following steps were performed for LPE growth. A Y₂O₃ crucible, having internal diameter of 50mm and height of 50mm, was filled with Y₂BaCuO₅ powder (of approximately 15g), as a solute supply source, 3BaO-7CuO powder (of approximately 240g), as a solvent, and ZnO powder (of approximately 10g), as an additive. Heated to about 1,000°C, the crucible was sufficiently kept at the temperature until the 3BaO-7CuO powder and ZnO powder completely melt.

Thereafter, surface temperature of the liquid was lowered to about 984°C and bottom temperature of the liquid was lowered to about 988°C so that a vertical temperature gradient is formed. The liquid surface was adjusted to be supersaturated for growth of Y123 phase.

To form an LPE film, the substrate surface was fixed perpendicular to a pulling rod. The seed film was placed onto the supersaturated liquid surface. Then, with rotation of 20 rpm for 20 minutes, the seed film was grown by LPE.

It was confirmed that the LPE-grown film obtained is Y123 crystal having thickness of about 20im, and the meandering shape of the seed film is maintained along the surface to an accuracy of several tens of im.

Subsequently, the LPE-grown film was heat-treated at 500°C for 200h in a pure oxygen gas-stream and the Y123 crystal was turned to superconducting phase.

The LPE-grown film was tested for conduction by the DC four-probe resistive method without any external magnetic fields being applied. The result showed that superconducting critical temperature of the film is about 50K.

Additionally, the film was tested for conduction at about 20K by the DC four-probe resistive method without any external magnetic fields being applied. It was found that critical current of the film is about 500A. These results confirmed that the LPE-grown film obtained is an excellent superconductor.

Subsequently, electric resistance in a normal conducting state at about 60K was evaluated. It was found that resistance of the film is about 3Ù. As a result, it was confirmed that the LPE film of the present invention has high electric resistivity in a normal conducting state.

### [Third Example]

A Y123 poly crystalline seed film, having thickness of approximately 0.1ìm, was grown onto an MgO (100) single crystalline substrate of 20×20×0.5mm³ by vapor deposition (pulsed laser deposition).

It was confirmed by an x-ray diffraction apparatus that c-axis of the seed film crystal (Y123) is oriented perpendicular to the substrate surface.

The following steps were performed for LPE growth. A Y₂O₃ crucible, having internal diameter of 50mm and height of 50mm, is filled with Y₂BaCuO₅ powder (of approximately 15g), as a solute supply source, and 3BaO-7CuO powder (of approximately 240g), as a solvent. Heated to about 1,000°C, the crucible was sufficiently kept at the temperature until the 3BaO-7CuO powder completely melts.

Thereafter, surface temperature of the liquid was lowered to about 984°C and bottom temperature of the liquid was lowered to about 988°C so that a vertical temperature gradient is formed. The liquid surface was adjusted to be supersaturated for growth of Y123 phase.

To form an LPE film, the substrate surface was fixed perpendicular to a pulling rod. The seed film was placed onto the supersaturated liquid surface. Then, with rotation of 20 rpm for 20 minutes, the whole seed film was grown by LPE.

It was confirmed that the LPE-grown film obtained is Y123 crystal having thickness of about 20ìm.

In order to form the LPE-grown film into a spiral shape of 3mm width and 2mm pitch, a mask was applied using a polyimide film, and chemical etching was performed with a nitric acid solution (of approximately 0.1N). The film was then washed with ethanol and the mask was removed. As a result, the LPE-grown film having a spiral shape was obtained.

Subsequently, the LPE-grown film was heat-treated at 500°C for 200h in a pure oxygen gas-stream and the Y123 crystal was turned to superconducting phase.

The LPE-grown film was tested for conduction by the DC four-probe resistive method without any external magnetic fields being applied. The result showed that superconducting critical temperature of the film is about 90K.

Additionally, the film was tested for conduction in liquid nitrogen (at about 77K) by the DC four-probe resistive method without any external magnetic fields being applied. It was found that critical current of the film is about 300A. These results confirmed that the LPE-grown film obtained is an excellent superconductor.

Subsequently, electric resistance in a normal conducting state at about 100K was evaluated. It was found that resistance of the film is about 4Ù. As a result, it was confirmed that the LPE film of the present invention has high electric resistivity in a normal conducting state.

### [Fourth Example]

A Y123 poly crystalline seed film, having thickness of approximately 0.1ìm, was grown onto an MgO (100) single crystalline substrate of 20×20×0.5mm³ by vapor deposition (thermal reactive co-evaporation).

It was confirmed by an x-ray diffraction apparatus that c-axis of the seed film crystal (Y123) is oriented perpendicular to the substrate surface.

The following steps were performed for LPE growth. A Y₂O₃ crucible, having internal diameter of 50mm and height of 50mm, was filled with Y₂BaCuO₅ powder (of approximately 15g), as a solute supply source, 3BaO-7CuO powder (of approximately 240g), as a solvent, and ZnO powder (of approximately 10g), as an additive. Heated to about 1,000°C, the crucible was sufficiently kept at the temperature until the 3BaO-7CuO powder and ZnO powder completely melt.

Thereafter, surface temperature of the liquid was lowered to about 984°C and bottom temperature of the liquid was lowered to about 988°C so that a vertical temperature gradient is formed. The liquid surface was adjusted to be supersaturated for growth of Y123 phase.

To form an LPE film, the substrate surface was fixed perpendicular to a pulling rod. The seed film was placed onto the supersaturated liquid surface. Then, with rotation of 20 rpm for 20 minutes, the whole seed film was grown by LPE.

It was confirmed that the LPE-grown film obtained is Y123 crystal having thickness of about 20ìm.

In order to form the LPE-grown film into a spiral shape of 3mm width and 2mm pitch, physical etching was performed only to an LPE crystal film portion using a laser processing apparatus. As a result, the LPE-grown film having a spiral shape was obtained.

Subsequently, the LPE-grown film was heat-treated at 500°C for 200h in a pure oxygen gas-stream and the Y123 crystal was turned to superconducting phase.

The LPE-grown film was tested for conduction by the DC four-probe resistive method without any external magnetic fields being applied. The result showed that superconducting critical temperature of the film is about 50K.

Additionally, the film was tested for conduction at about 20K by the DC four-probe resistive method without any external magnetic fields being applied. It was found that critical current of the film is about 500A. These results confirmed that the LPE-grown film obtained is an excellent superconductor.

Subsequently, electric resistance in a normal conducting state at about 60K was evaluated. It was found that resistance of the film is about 3Ù. As a result, it was confirmed that the LPE film of the present invention has high electric resistivity in a normal conducting state.

### [Fifth Example]

An Nd123 poly crystalline seed film, having thickness of approximately 0.1ìm, was grown onto an MgO (100) single crystalline substrate of 20×20×0.5mm³ by vapor deposition (thermal reactive co-evaporation).

It was confirmed by an x-ray diffraction apparatus that c-axis of the seed film crystal (Nd123) is oriented perpendicular to the substrate surface.

In order to form the seed film into a meandering shape of 3mm width and 2mm pitch, a mask was applied using a polyimide film, and chemical etching was performed with a dilute nitric acid solution (of approximately 0.01N). The film was then washed with ethanol and the mask was removed. As a result, the seed film having a meandering shape was obtained.

The following steps were performed for LPE growth. An Nd₂O₃ crucible, having internal diameter of 50mm and height of 50mm, was filled with 3BaO-5CuO powder (of approximately 240g), as a solvent. Heated to about 1,085°C, the crucible was sufficiently kept at the temperature until the 3BaO-5CuO powder completely melts.

Thereafter, surface temperature and bottom temperature of the liquid were adjusted to be substantially the same (liquid surface temperature a liquid bottom temperature à 1,070°C) so that a vertical temperature gradient is not formed. Nd123 produces a smaller liquidus-line gradient around peritectic temperature and has larger solubility than Y123. Therefore, in order to avoid excessive supersaturation on the liquid surface, the seed film is grown without allowing a vertical temperature gradient to be formed. The solute for Nd123 crystal growth is supplied from the Nd₂O₃ crucible. Supersaturation as a driving force occurs as a result of a temperature difference (solubility difference) between the temperature upon elevation (about 1,085°C) and the temperature upon film forming (about 1,070°C).

To form an LPE film, the substrate surface was fixed perpendicular to a pulling rod. The seed film was placed onto the supersaturated liquid surface. Then, with rotation of 20 rpm for 2 minutes, the seed film was grown by LPE.

It was confirmed that the LPE-grown film obtained is Nd123 crystal having thickness of about 20im, and the meandering shape of the seed film is maintained along the surface to an accuracy of ten to several tens of ìm.

It was also confirmed by composition analysis using an electron probe microanalyzer that Nd:Ba à1.2:1.8.

Subsequently, the LPE-grown film was heat-treated at 400°C for 200h in a pure oxygen gas-stream and the Nd123 crystal was turned to superconducting phase.

The LPE-grown film was tested for conduction by the DC four-probe resistive method without any external magnetic fields being applied. The result showed that superconducting critical temperature of the film is about 50K.

Additionally, the film was tested for conduction at about 20K by the DC four-probe resistive method without any external magnetic fields being applied. It was found that critical current of the film is about 480A. These results confirmed that the LPE-grown film obtained is an excellent superconductor.

Subsequently, electric resistance in a normal conducting state at about 60K was evaluated. It was found that resistance of the film is about 3Ù. As a result, it was confirmed that the LPE film of the present invention has high electric resistivity in a normal conducting state.

Two comparative examples are shown in the following.

### [First Comparative Example]

Y₂O₃ powder, BaCO₃ powder, and CuO powder, respectively weighed on scales so that Y:Ba:Cu=1.2:2.1:3.1, were mixed well to be even.

The mixed powder obtained was heat-treated at about 900°C for 50h in the atmosphere, and then comminuted thoroughly. The above heat-treatment and comminution were repeated three times more to obtain homogenous powder.

The prepared powder was filled into a rubber tube and molded, by way of cold isostatic press, into a sample having external diameter of about φ2.5mm and length of about 70mm.

The molded rod-like sample was heat-treated at about 950°C for 50h in the atmosphere. Aprecursor sample was obtained.

The precursor sample was produced into a quasi single crystalline rod-like material, having external diameter of about φ 2mm and length of about 45mm, using a vertical directional solidification apparatus in unidirectional solidification, under conditions that the maximum temperature à1,020°C, temperature gradient à20°C/mm, and sample traveling speed à1mm/h.

Subsequently, the quasi single crystalline rod-like material was heat-treated at 500°C for 200h in a pure oxygen gas-stream and Y123 crystal was turned to superconducting phase.

The quasi single crystalline rod-like material was tested for conduction by the DC four-probe resistive method without any external magnetic fields being applied. The result showed that superconducting critical temperature of the material is about 90K.

Additionally, the material was tested for conduction in liquid nitrogen (at about 77K) by the DC four-probe resistive method without any external magnetic fields being applied. It was found that critical current of the material is about 300A. These results confirmed that the material is an excellent superconductor.

Subsequently, electric resistance in a normal conducting state at about 100K was evaluated. It was found that resistance of the material is about 70mÙ. The resistance value in the present example is about 2-digit smaller than those in the aforementioned examples. As a result, it was confirmed that the rod-like material in the present comparative example cannot achieve high electric resistivity in a normal conducting state.

### [Second Comparative Example]

Bi₂O₃ powder, PbO powder, SrCO₃ powder, CaCO₃ powder, and CuO powder, weighed on scales so that Bi:Pb:Sr:Ca:Cu=1.8:0.3:2:2:3, were mixed well to be even.

The mixed powder obtained was heat-treated at about 800°C for 50h in the atmosphere, and then comminuted thoroughly. The above heat-treatment and comminution were repeated three times more to obtain homogenous powder.

The prepared powder was filled into an Ag pipe having external diameter of φ6mm and internal diameter of φ5mm. After drawn to have external diameter of φ1mm by a drawing method, the sample obtained was rolled into a tape-like shape having 0.18mmt×2mmw using a roller.

The rolled tape-like sample was heat-treated at about 845°C for 50h in the atmosphere, and again rolled into a tape of 0.15mmt×2.5mmw.

Then, the above heat-treatment and rolling were further performed to obtain a tape-like sample of 0.12mmt×3mmw. The above heat-treatment was again performed to finally produce an Ag sheathed Bi oxide superconducting wire material.

The wire material was tested for conduction by the DC four-probe resistive method without any external magnetic fields being applied. The result showed that superconducting critical temperature of the material is about 110K.

Additionally, the Ag sheathed Bi oxide superconducting wire material prepared as above was layered double in 50mm length. The material was tested for conduction in liquid nitrogen (at about 77K) by the DC four-probe resistive method without any external magnetic fields being applied. It was found that critical current of the material is about 300A. These results confirmed that the material is an excellent superconductor.

Subsequently, electric resistance in a normal conducting state at about 120K was evaluated. It was found that the material has resistance of about 0.5mÙ. The resistance value in the present example is about 4-digit smaller than those in the aforementioned examples. As a result, it was confirmed that, the Ag sheathed Bi oxide superconducting wire material in the present comparative example requires about 4-digit longer conducting length than a superconductor having a composition like the one in the present invention, in order to achieve high electric resistance in a normal conducting state.

### INDUSTRIAL AVAILABILITY

The present invention provides a persistent current switch which operates at operating temperature higher than that of a metallic superconducting wire, and which is smaller, lighter and higher in electric resistance in a normal conducting state than an oxide superconducting Ag sheathed wire. Such a persistent current switch renders possible low-cost superconducting technique applied apparatus which save energy and have stability.

## Claims

1. A persistent current switch material comprised of a thick-film crystal grown by LPE.

2. The persistent current switch material wherein a conductor portion of the LPE-grown crystal set forth in claim 1 has a meandering shape, thus allowing the switch to be small but long in conductor length.

3. The persistent current switch material wherein a conductor portion of the LPE-grown crystal set forth in claim 1 has a spiral shape, thus allowing the switch to be small but long in conductor length.

4. The persistent current switch material wherein an RE 123 (RE₁Ba₂Cu₃O_{y}) superconductor (RE represents Y and rare earth element) is used as the LPE-grown thick-film crystal set forth in claim 1 which comprises a conductor portion.

5. The persistent current switch material wherein an LPE-grown thick-film crystal added with one of an element such as Zn, Mg, etc. and a combination of such elements is used as the RE123 (RE₁Ba₂Cu₃O_{y}) superconductor (RE represents Y and rare earth element) set forth in claim 4.

6. The persistent current switch material wherein one of Nd123 and Sm123 superconductor is used as the RE123 (RE₁Ba₂Cu₃O_{y}) superconductor (RE represents Y and rare earth element) set forth in claim 4 and wherein an LPE-grown thick-film crystal of which superconducting critical temperature (Tc) is controlled so that 30K□...Tc□...96K by controlling a composition ratio of RE:Ba is used.

7. A production method of a persistent current switch material wherein a seed film is grown by LPE after pre-processed into a predetermined shape.

8. A production method of a persistent current switch material wherein a thick-film crystal grown by LPE is physically or chemically processed into a predetermined shape.

9. The persistent current switch material wherein a conductor portion of the switch produced by the method set forth in claim 7 or 8 has one of a meandering shape and a spiral shape, thus allowing the switch to be small but long in conductor length.

10. The persistent current switch material wherein an RE123 superconductor (RE represents Y and rare earth element) is used as the LPE-grown thick-film crystal which comprises a conductor portion produced by the method set forth in claim 7 or 8.

11. The persistent current switch material wherein an RE123 superconductor (RE represents Y and rare earth element) is used as the LPE-grown thick-film crystal which comprises a conductor portion produced by the method set forth in claim 7 or 8 added with one of an element such as Zn, Mg, etc. and a combination of such elements.

12. The persistent current switch material wherein one of Nd123 and Sm123 superconductor is used as the RE123 (RE₁Ba₂Cu₃O_{y}) superconductor (RE represents Y and rare earth element) produced by the method set forth in claim 7 or 8 and wherein an LPE-grown thick-film crystal of which superconducting critical temperature (Tc) is controlled so that 30K□...Tc□...96K by controlling composition ratio of RE:Ba is used.
